# EUROPÄISCHE PATENTSCHRIFT

(11) **EP 1 450 591 B1**
(45) Veröffentlichungstag und Bekanntmachung des Hinweises auf die Patenterteilung: **01.07.2009**
(21) Anmeldenummer: 03104762.4
(22) Anmeldetag: 17.12.2003
(51) Int. Cl.: H05K 7/14

(54) **Lösbare Befestigungsvorrichtung für ein elektronisches Modul**
Releasable fastening device for electronic modul
Dispositif de fixation détachable pour un module électronique

(30) Priorität: 18.02.2003 DE 10306783
(43) Veröffentlichungstag der Anmeldung: 25.08.2004
(73) Patentinhaber: Continental Automotive GmbH, 30165 Hannover (DE)
(72) Erfinder: Klein, Martin, 35638, Leun (DE); Müller, Steffen, 35625, Hüttenberg (DE); Seifert, Roland, 69115, Heidelberg (DE)

(56) Entgegenhaltungen:
- EP-A- 0 810 419
- DE-U1- 29 520 061
- JP-A- 2002 349 943

## Beschreibung

Die Erfindung bezieht sich auf eine lösbare Befestigungsvorrichtung für ein elektronisches Modul, insbesondere für einen GPS-Empfänger eines Kraftfahrzeugs, an einer Seitenwand eines Blechrahmens, mit einem etwa kastenartigen Gehäuse des Moduls, von dem ein Anschlußteil, insbesondere ein Antennenanschlußteil hervorsteht und durch eine Anschlußöffnung einer Wand des Blechrahmens ragt, mit von dem kastenförmigen Gehäuse hervorstehenden Fixierelementen, die in der Befestigungslage des Moduls an dem Blechrahmen durch Fixieröffnungen in der Seitenwand des Blechrahmens ragen und mit radialen Erweiterungen an dem Umgebungsbereich der Fixieröffnungen diesen umgreifend auf der dem Modul abgewandten Seite der Seitenwand des Moduls anliegen, mit Montageöffnungen in der Seitenwand, in die die Fixieröffnungen über in gleiche Richtung sich erstreckende Einführbereiche münden, wobei die radialen Erweiterungen quer zur Ebene der Seitenwand durch die Montageöffnungen und die Fixierelemente in der Ebene der Seitenwand durch die Einführbereiche hindurchführbar sind.

Bei einer derartigen Befestigungsvorrichtung ist es bekannt, daß in einer etwa rechtwinklig zur Seitenwand eines Blechrahmens sich erstreckenden Rückwand des Blechrahmens die Anschlußöffnung als Bohrung ausgebildet ist. In einem Abstand von der Rückwand sind an der Seitenwand im Abstand zueinander zwei Fixieröffnungen ausgebildet, von denen in von der Rückwand entfernender Richtung Einführöffnungen zu Montageöffnungen führen.

Das Modul besitzt an seiner einen Stirnseite ein hervorstehendes zylindrisches Antennenanschlußteil, das mit einem Außengewinde versehen ist und einen etwas geringeren Außendurchmesser besitzt, als es der Durchmesser der Anschlußöffnung der Rückwand ist.

An der der Seitenwand zugewandten Seite besitzt das Modul in seinem der Rückwand abgewandten Endbereich entsprechend der Fixieröffnungen zwei hervorstehende Fixierelemente mit radialen Erweiterungen an ihren freien Enden.

Zur Befestigung des Moduls am Blechrahmen werden das Anschlußteil des Moduls in die Anschlußöffnung und die Fixierelemente in die Montageöffnungen eingeführt. Danach erfolgt eine Verschiebung des Moduls parallel zur Seitenwand in Richtung zur Rückwand, bis das Modul mit seiner Stirnwand in Anlage an der Rückwand des Blechrahmens ist. Dabei bewegen sich gleichzeitig die Fixierelemente durch die Einführbereiche in die Fixieröffnungen und liegen mit ihren radialen Erweiterungen auf der dem Modul abgewandten Seite der Seitenwand an den Umgebungsbereichen der Fixieröffnungen an. Von der dem Modul abgewandten Seite der Rückwand des Blechrahmens her wird zunächst eine Unterlegscheibe auf das Antennenanschlußteil aufgesteckt und dann eine Überwurfmutter auf das Außengewinde des Antennenanschlußteils aufgeschraubt und damit das Modul mit dem Blechrahmen auf lösbare Weise fest verbunden.

Diese Ausbildung benötigt viele Bauteile und einen großen Montageaufwand.

Darüber hinaus wird das Anschlußteil mit erheblichen Kräften durch die Überwurfmutter beaufschlagt. Weiterhin bildet das Antennenanschlußteil gleichzeitig ein Befestigungselement des Moduls und wird somit durch alle auf das Modul einwirkenden Kräfte ebenfalls belastet.

Aufgabe der Erfindung ist es daher eine lösbare Befestigungsvorrichtung der eingangs genannten Art zu schaffen, bei der das Modul einfach montierbar und demontierbar sowie das Anschlußteil frei von Befestigungskräften des Moduls am Blechrahmen ist.

Diese Aufgabe wird erfindungsgemäß dadurch gelöst, daß an dem Gehäuse des Moduls wenigstens ein Federelement angeordnet ist, das unter federnder Vorspannung an der dem Modul zugewandten Fläche der Seitenwand abstützbar ist und einen zur Seitenwand gerichteten Rastansatz besitzt, der in der Befestigungslage federnd in eine Rastöffnung etwa entsprechenden Querschnitts des Blechrahmens eingerastet ist.

Durch diese Ausbildung wird zur Montage des Moduls dieses mit seinem Anschlußteil in die Anschlußöffnung und mit den Fixierelementen quer zur Ebene der Seitenwand in die Montageöffnungen der Seitenwand eingeführt. Dabei gelangt das Federelement und der Rastansatz unter federnder Vorspannung zur Anlage an der Seitenwand. Danach wird das Modul parallel zur Seitenwand verschoben und die Fixierelemente gelangen durch die Einführbereiche in die Fixieröffnungen. In dieser Befestigungslage ist der Rastansatz zu der Rastöffnung gelangt und in diese eingerastet. Damit sichert der in die Rastöffnung eingerastete Rasteinsatz das Modul in seiner Befestigungslage, während das Federelement die radialen Erweiterungen der Fixierelemente unter Vorspannung gegen die Umgebungsbereiche der Fixieröffnungen auf der dem Modul abgewandten Seite der Seitenwand zieht und erschütterungsfrei sicher hält.

Da das Federelement und der Rastansatz vormontierbar sind, werden zum Einbau des Moduls in den Blechrahmen keine weiteren Bauteile benötigt, so daß über ein einfaches Aufstecken und Einrasten eine kostengünstige Montage des Moduls erfolgt. Dabei bleibt das Anschlußteil völlig frei von irgendwelchen Montage- und Haltekräften.

Eine Demontage des Moduls, wie sie z.B. zu einer Wartung oder zu einem Austausch des Moduls erforderlich ist, ist ebenfalls ohne besondere Werkzeuge auf einfache Weise möglich.

Um eine gleichmäßige Abstützung des Moduls an der Seitenwand zu erreichen, kann in den einander entgegengesetzten Endbereichen des Moduls jeweils ein Federelement angeordnet und vorzugsweise in diesen Endbereichen auch jeweils zwei im Abstand zueinander angeordnete Fixierelemente und Fixieröffnungen vorhanden sein. Dabei ist vorzugsweise die Abstützstelle des Federelements zwischen zwei Fixierelementen positioniert.

Zur gleichmäßigen Abstützung kann das Federelement mehrere Federarme besitzen, von denen zwei sich entgegengesetzt jeweils zu einem Randbereich des Moduls erstrecken.

Ist der Rastansatz im Verbindungsbereich der Federarme angeordnet, so erhält man eine weitere Bauteilreduzierung.

Dabei können die einander etwa entgegengesetzt sich erstreckenden Federarme derart unter einem Winkel zueinander geneigt sein, daß an ihrem Verbindungsbereich der größte Abstand zu dem Gehäuse des Moduls besteht.

Zur einfachen Vormontage sind die sich zum Randbereich des Moduls erstreckenden Enden der Federarme an Befestigungsstellen an dem Gehäuse des Moduls befestigbar.

Ist der Verbindungsbereich der etwa einander entgegengesetzt sich erstreckenden Federarme außerhalb einer Verbindungslinie zwischen den Befestigungsstellen angeordnet, was auf einfache Weise dadurch möglich ist, daß das Federelement etwa U-förmig ausgebildet ist und aus zwei spiegelbildlich zueinander angeordneten L-förmigen Federarmen besteht, in deren Verbindungsbereich der Rastansatz angeordnet ist, so bilden die an dem Modul befestigten Schenkel des "L" der Federarme einseitig eingespannte und weitgehend frei federnde Federarme.

Einfach und kostengünstig herstellbar ist es, wenn das Federelement ein einteiliges, insbesondere aus Kunststoff bestehendes Bauteil ist.

Auf eine spezielle Montage von Erdungselementen bei dem Einbau des Moduls kann verzichtet werden, wenn an einem Erdungsbereich des Gehäuses des Moduls oder an einer Wand des mit Erde verbundenen Blechrahmens insbesondere eine als Erdungsfederarm ausgebildete Erdungsfeder angeordnet ist, die mit federnder Vorspannung an einem Erdungsbereich des Gehäuses des Moduls oder an einer Wand des Blechrahmens in Anlage ist.

Einen einfachen und symmetrischen Aufbau weisen die Fixierelemente und radialen Erweiterungen auf, wenn sie einen Kreisquerschnitt besitzen.

Dabei können die Fixierelemente bolzenartig ausgebildet sein und eine radial umlaufende Nut besitzen, deren Nutbreite etwa der Dicke der Seitenwand des Blechrahmens und deren Durchmesser am Nutengrund etwa der Breite der Fixieröffnung und des Einführbereichs entspricht.

In einfacher Weise können die Fixieröffnungen mit den Einführbereichen durch Langlöcher gebildet sein.

Ist ein Teil des Umgebungsbereichs der Fixieröffnungen als Federarm ausgebildet und federnd an der einen Seitenwand, insbesondere der dem Modul entfernteren Seitenwand der Nut in Anlage, während der andere Teil des Umgebungsbereichs an der anderen Seitenwand der Nut abgestützt ist, so werden die Fixierelemente zusätzlich in ihrer Befestigungslage gehalten.

Zur Vereinfachung der Montage des Moduls kann die Anschlußöffnung ein Langloch sein, das sich etwa parallel zur Erstreckung der Einführbereiche erstreckt.

Das Anschlußteil kann sich parallel zu den Fixierelementen erstrecken und eine Anschlußöffnung in der Seitenwand des Blechrahmens durchragen. Vorzugsweise erstreckt sich aber das Anschlußteil etwa parallel zur Ebene der Seitenwand des Blechrahmens und die Anschlußöffnung ist in einer zur Seitenwand etwa rechtwinklig sich erstreckenden Rückwand des Blechrahmens ausgebildet.

Einfach und kostengünstig herstellbar ist es, wenn der Blechrahmen ein Stanz/Biegebauteil ist und insbesondere aus einem Metall besteht.

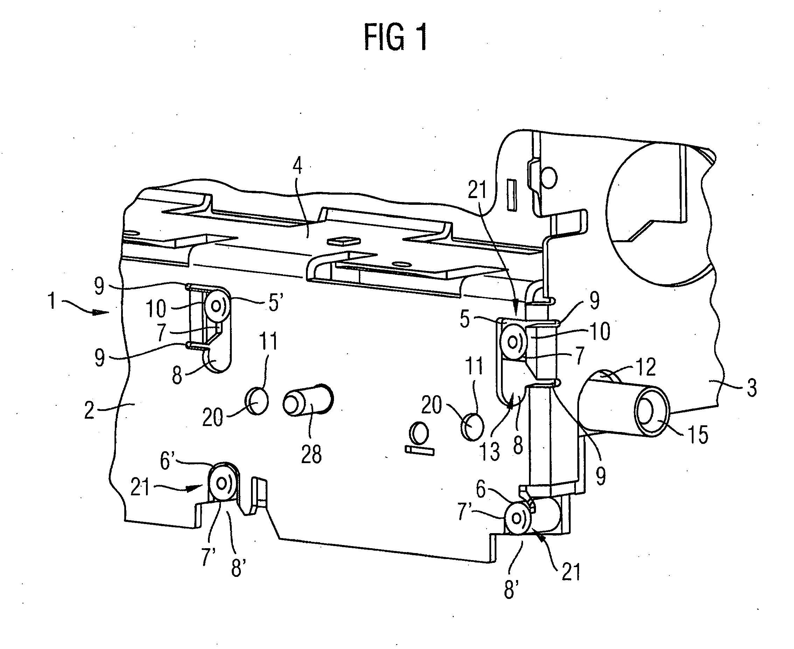

Ein Ausführungsbeispiel der Erfindung ist in der Zeichnung dargestellt und wird im folgenden näher beschrieben. Es zeigen
- Figur 1: eine perspektivische Ansicht eines an einem Blechrahmen befestigen elektronischen Moduls

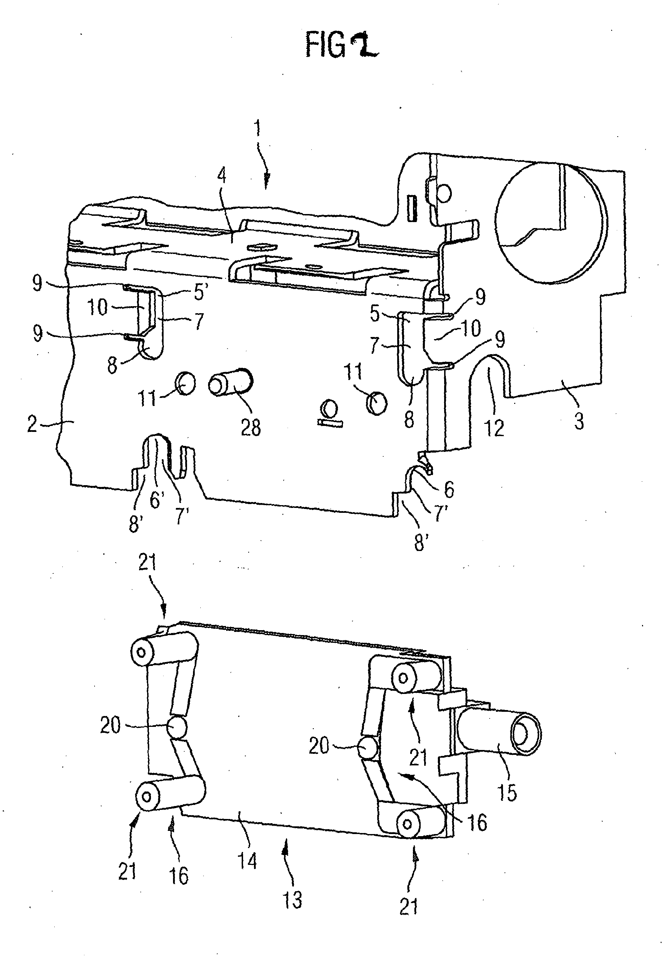

- Figur 2: eine perspektivische Außenansicht des Blechrahmens und des Moduls nach Figur 1

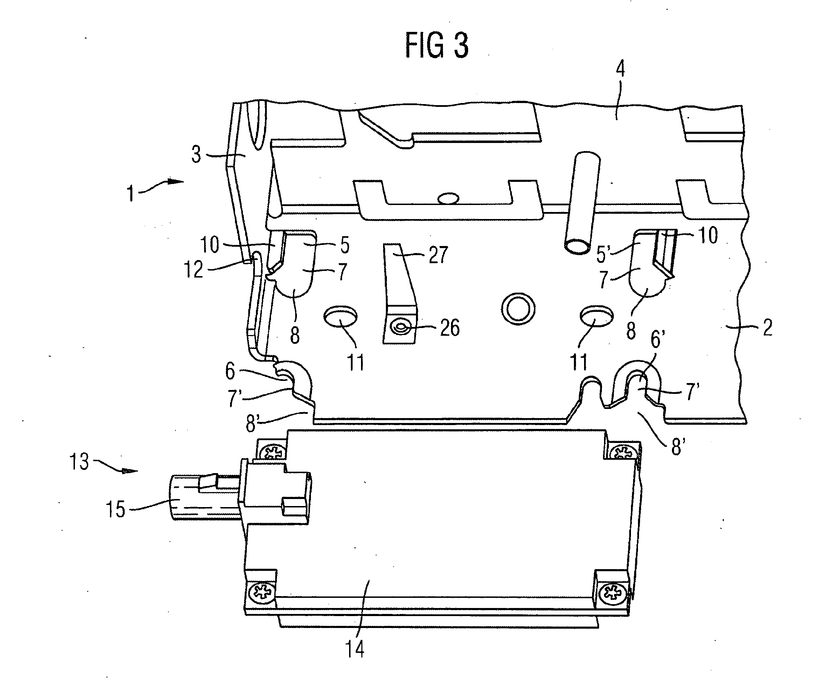

- Figur 3: eine perspektivische Innenansicht des Blechrahmens und des Moduls nach Figur 1

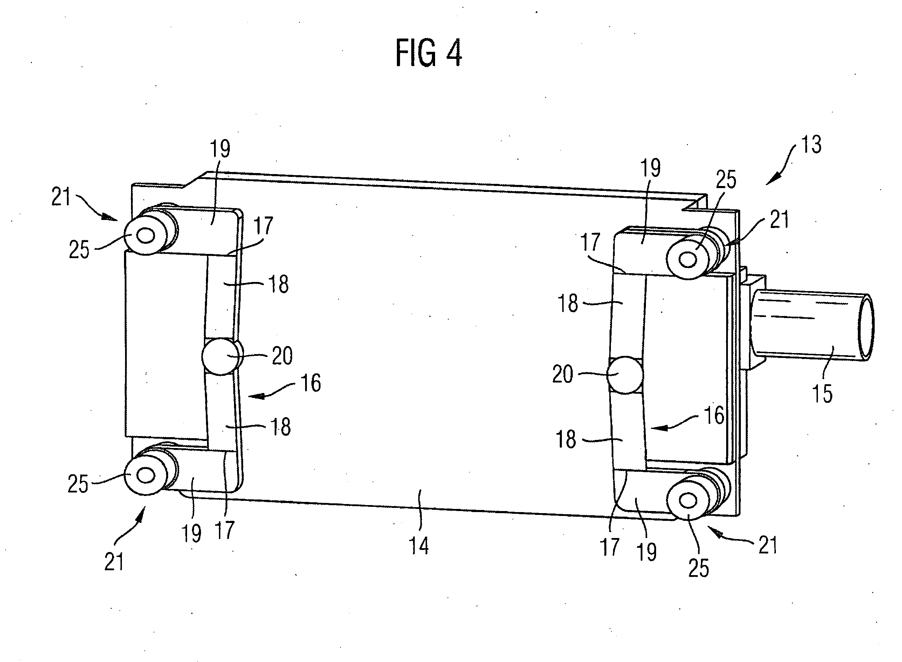

- Figur 4: eine perspektivische Seitenansicht des mit Federelementen versehenen Moduls nach Figur 1

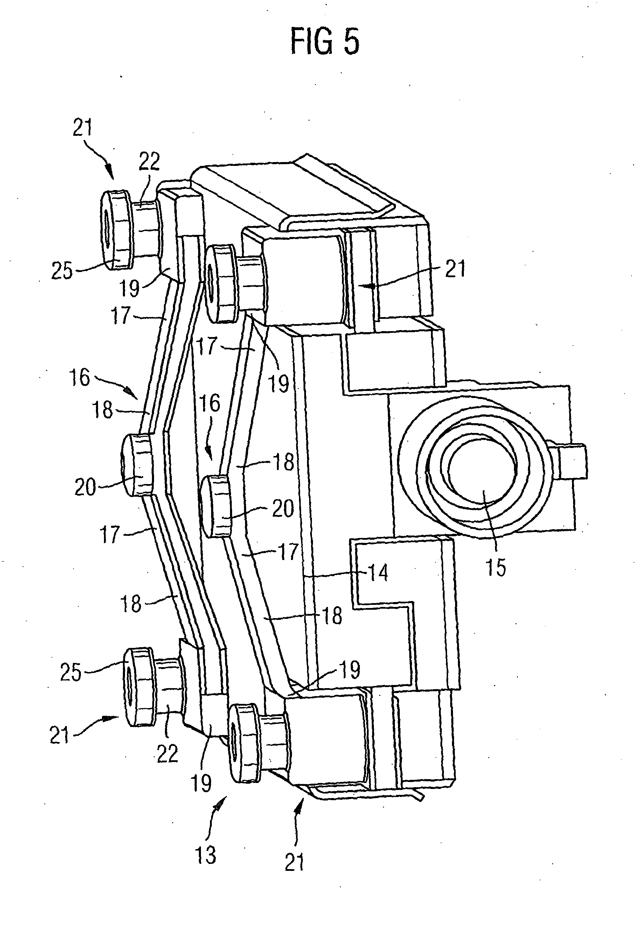

- Figur 5: eine perspektivische Seitenansicht des mit Federelementen versehenen Moduls nach Figur 1

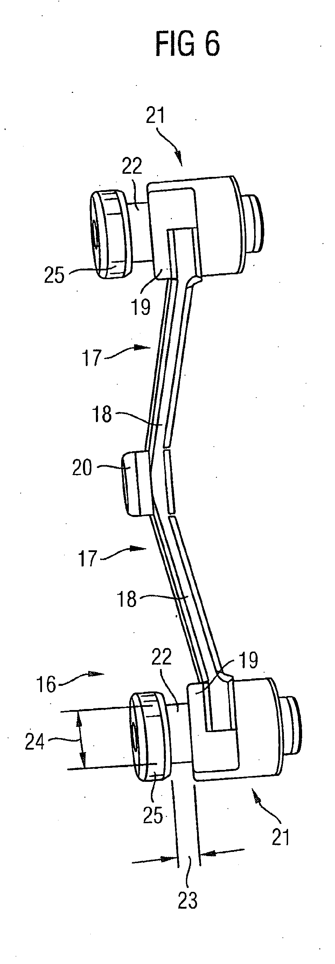

- Figur 6: eine Seitenansicht des Federelements des Moduls nach Figur 1

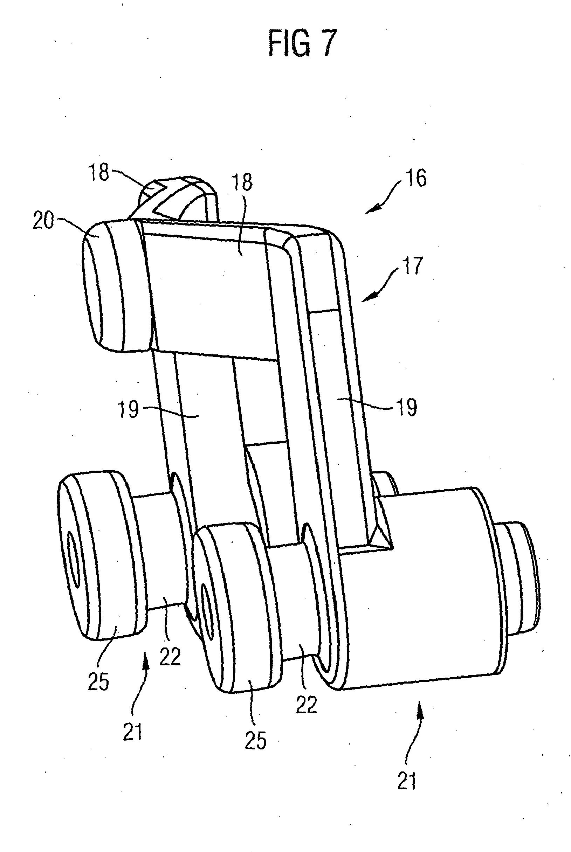

- Figur 7: eine perspektivische Ansicht des Federelements des Moduls nach Figur 1

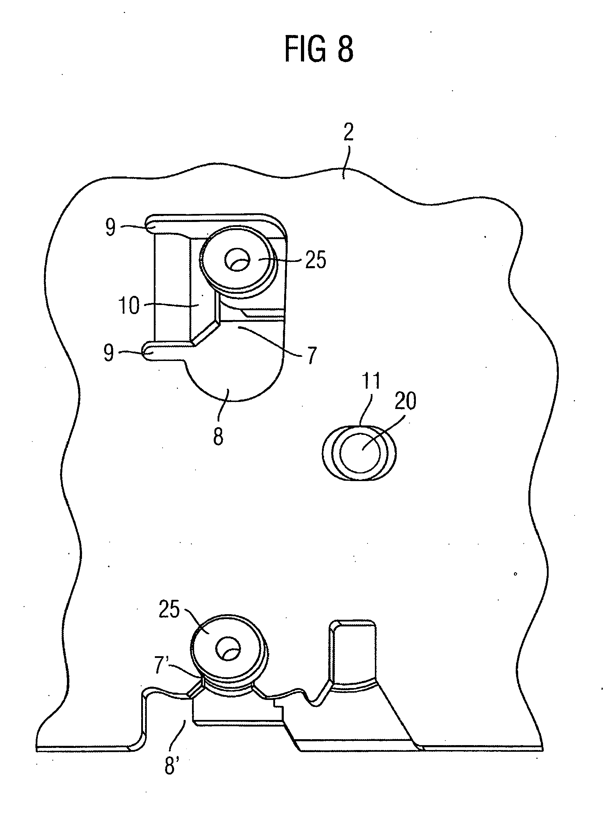

- Figur 8: einen perspektivischen Ausschnitt des an dem Blechrahmen befestigten Moduls nach Figur 1

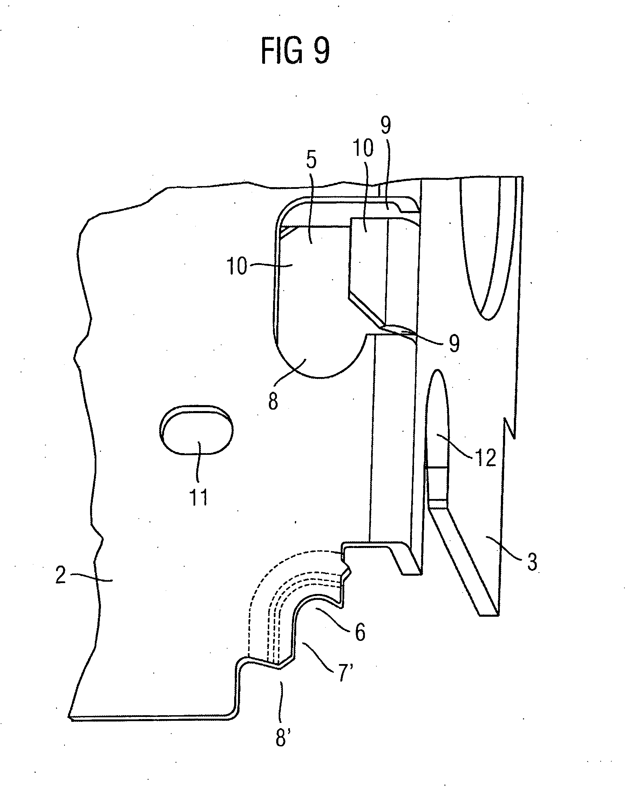

- Figur 9: einen perspektivischen Ausschnitt des Blechrahmens nach Figur 1

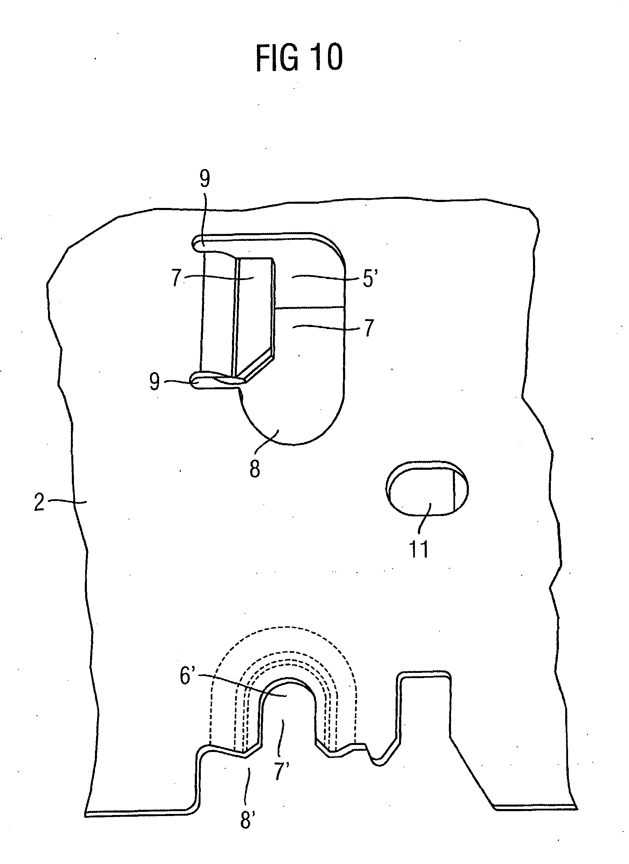

- Figur 10: einen weiteren perspektivischen Ausschnitt des Blechrahmens nach Figur 1.

In den Figuren ist ein metallischer Blechrahmen 1 vorhanden, der aus einer etwa rechteckigen Seitenwand 2 und einer an deren kurzen Seite rechtwinklig davon abgebogenen Rückwand 3 besteht. Weiterhin ist an der oberen Längsseite der Seitenwand 2 rechtwinklig eine Deckwand 4 abgebogen.

In einem kurzen Abstand etwa parallel zur Abwinklung der Rückwand 3 sind im Abstand zueinander zwei Fixieröffnungen 5 und 6 ausgebildet. Weitere zwei Fixieröffnungen 5' und 6' sind mit gleichem Abstand zueinander parallel zu den Fixieröffnungen 5 und 6 ausgebildet.

Die Fixieröffnungen 5, 5', 6, 6' bilden zusammen mit daran anschließenden Einführbereichen parallel zur Abwinklung der Rückwand 3 nach unten gerichtete Langlöcher 7 und 7', die in Montageöffnungen 8, 8' münden.

Eine Längsseite der oberen Langlöcher 7 ist durch quer zu den Langlöchern 7 in der Seitenwand 2 ausgebildeten Schlitzen 9 zu Federarmen 10 ausgebildet, deren zu den Langlöchern 7 gerichteten freien Enden aus der Ebene der Seitenwand 2 heraus abgebogen sind.

Die Montageöffnungen 8' der unteren Langlöcher 7' münden offen am unteren Rand der Seitenwand 2 nach außen.

Mittig zwischen den oberen und unteren Fixieröffnungen 5, 5', 6, 6' sind in einem Abstand in Längserstreckung der Seitenwand 2 zueinander durchgehende Rastöffnungen 11 in der Seitenwand 2 ausgebildet. Weiterhin ist in der Rückwand 3 eine als Langloch ausgebildete Anschlußöffnung 12 angeordnet, die sich etwa parallel zur Erstreckung der Langlöcher 7, 7' erstreckt und an ihrem unteren Ende offen nach außen mündet. Ein elektronisches Modul 13 mit einem rechteckigen kastenartigen Gehäuse 14 und einem an einer Stirnseite hervorstehenden zylindrischen Anschlußteil 15 ist an seinen Endbereichen in Längserstreckung mit Federelementen 16 versehen. Diese Federelemente 16 bestehen jeweils aus zwei Federarmen 17, die L-förmig ausgebildet und an den Enden ihrer langen Schenkel 18 so miteinander verbunden sind, daß sie sich in einer Linie erstrecken. Die kurze Schenkel 19 sind in gleiche Richtung gerichtet, so daß die miteinander verbundenen Federarme 17 ein "U" bilden.

Die langen Schenkel 18 der Federarme 17 sind unter einem Winkel zueinander geneigt, so daß sie ein weit offenes "V" bilden. An ihrem Verbindungsbereich ist auf der äußeren Spitze des "V" ein Rastansatz 20 angeordnet.

An den freien Enden der kurzen Schenkel 19 der Federarme 17 sind bolzenartig ausgebildete Fixierelemente 21 mit einem Kreisquerschnitt angeordnet, die etwa parallel zum Rastansatz 20 sich erstrecken und in die gleiche Richtung wie der Rastansatz 20 von den Federarmen 17 hervorstehen. An ihren freien Endbereichen besitzen die Fixierelemente 21 eine radial umlaufende Nut 22, deren Nutbreite 23 etwa der Dicke der Seitenwand 2 des Blechrahmens 1 entspricht und deren Durchmesser 24 am Nutgrund etwa der Breite der Fixieröffnung 5, 5', 6, 6' entspricht.

Der Bereich zwischen der Nut 22 und dem freien Ende des Fixierelements 21 bildet eine radiale Erweiterung 25 mit einem Kreisquerschnitt, der kleiner als die Montageöffnungen 8, 8' und größer als die Fixieröffnungen 5, 5', 6, 6' ist.

Die kurzen Schenkel 19 der Federarme 17 sind etwa im mittleren Bereich der Fixierelemente 21 mit diesen fest verbunden. Mit ihren der radialen Erweiterung 25 entgegengesetzten Enden sind die Fixierelemente 21 derart fest an dem Gehäuse 14 des Moduls 13 angeordnet, daß der Verbindungsbereich der Federarme 17 den größten Abstand zu dem Gehäuse 14 des Moduls 13 besitzt.

Zur Befestigung des Moduls 13 an dem Blechrahmen 1 wird das Modul 13 mit seinen Fixierelementen 21, die die gleiche Anordnung zueinander wie die Montageöffnungen 8, 8' zueinander und die Fixieröffnungen 5, 5', 6, 6' zueinander aufweisen, unter vorspannender Auflage des Rastansatzes 20 auf der Seitenwand 2 in die Montageöffnungen 8, 8' eingeführt. Dabei erfolgt auch ein Einführen des Anschlußteils 15 in die Anschlußöffnung 12 der Rückwand 3. Durch Verschieben des Gehäuses 14 des Moduls 13 parallel zur Seitenwand 2 gelangen die Fixierelemente 21 durch die Langlöcher 7, 7' bis in die Fixieröffnungen 5, 5', 6, 6'.

In dieser Befestigungslage rasten die Rasteinsätze 20 in die Rastöffnungen 11 der Seitenwand 2 ein und halten das Modul 13 unverschiebbar in dieser Position an der Seitenwand 2.

Die Fixierelemente 21 umgreifen mit ihren radialen Erweiterungen 25 die Umgebungsbereiche der Fixieröffnungen 5, 5', 6, 6' in der Seitenwand 2, wobei die Federarme 10 für eine axial spielfreie Halterung der Fixierelemente 21 an der Seitenwand 2 sorgen.

An der dem Modul 13 zugewandten Seite der Seitenwand 2 ist mittels eines Nietes 26 ein Erdungsfederarm 27 befestigt, der mit seinem freien Ende von der Seitenwand 2 absteht und mit federnder Vorspannung an einem Erdungsbereich des Gehäuses 14 des Moduls 13 in Anlage ist. Der Schaft 28 des Niets 26 ragt auf der dem Modul 13 abgewandten Seite der Seitenwand 2 hervor und bildet einen Anschluß zum Erden des Moduls 13.

Das Modul 13 ist das elektronische Modul eines GPS-Empfängers für eine Navigationseinrichtung in einem Kraftfahrzeug, in dem der Blechrahmen 1 fest angeordnet ist, der als Halterung für das Modul 13 dient. Das Anschlußteil ist ein Antennenanschlußteil zum Anschließen einer Antenne zum Empfang der GPS-Daten.

## Patentansprüche

1. Lösbare Befestigungsvorrichtung für ein elektronisches Modul, insbesondere für einen GPS-Empfänger eines Kraftfahrzeugs, an einer Seitenwand eines Blechrahmens, mit einem etwa kastenartigen Gehäuse des Moduls, von dem ein Anschlußteil, insbesondere ein Antennenanschlußteil hervorsteht und durch eine Anschlußöffnung einer Wand des Blechrahmens ragt, mit von dem kastenförmigen Gehäuse hervorstehenden Fixierelementen, die in der Befestigungslage des Moduls an dem Blechrahmen durch Fixieröffnungen in der Seitenwand des Blechrahmens ragen und mit radialen Erweiterungen an dem Umgebungsbereich der Fixieröffnungen diesen umgreifend auf der dem Modul abgewandten Seite der Seitenwand des Moduls anliegen, mit Montageöffnungen in der Seitenwand, in die Fixieröffnungen über in gleiche Richtung sich erstreckende Einführbereiche münden, wobei die radialen Erweiterungen quer zur Ebene der Seitenwand durch die Montageöffnungen und die Fixierelemente in der Ebene der Seitenwand durch die Einführbereiche hindurchführbar sind, **dadurch gekennzeichnet, daß** an dem Gehäuse (14) des Moduls (13) wenigstens ein Federelement (16) angeordnet ist, das unter federnder Vorspannung an der dem Modul (13) zugewandten Fläche der Seitenwand (2) abstützbar ist und einen zur Seitenwand (2) gerichteten Rastansatz (20) besitzt, der in der Befestigungslage federnd in eine Rastöffnung (11) etwa entsprechenden Querschnitts des Blechrahmens (1) eingerastet ist.

2. Befestigungsvorrichtung nach Anspruch 1, **dadurch gekennzeichnet, daß** in den einander entgegengesetzten Endbereichen des Moduls (13) jeweils ein Federelement (16) angeordnet ist.

3. Befestigungsvorrichtung nach einem der vorhergehenden Ansprüche, **dadurch gekennzeichnet, daß** das Federelement (16) mehrere Federarme (17) besitzt, von denen zwei sich etwa entgegengesetzt jeweils zu einem Randbereich des Moduls (13) erstrecken.

4. Befestigungsvorrichtung nach Anspruch 3, **dadurch gekennzeichnet, daß** der Rastansatz (20) im Verbindungsbereich der Federarme (17) angeordnet ist.

5. Befestigungsvorrichtung nach einem der Ansprüche 3 und 4, **dadurch gekennzeichnet, daß** die einander etwa entgegengesetzt sich erstreckenden Federarme (17) derart unter einem Winkel zueinander geneigt sind, daß an ihrem Verbindungsbereich der größte Abstand zu dem Gehäuse (14) des Moduls (13) besteht.

6. Befestigungsvorrichtung nach einem der Ansprüche 3 bis 5, **dadurch gekennzeichnet, daß** die sich zum Randbereich des Moduls (13) erstreckenden Enden der Federarme (17) an Befestigungsstellen an dem Gehäuse (14) des Moduls (13) befestigbar sind.

7. Befestigungsvorrichtung nach einem der Ansprüche 3 bis 6, **dadurch gekennzeichnet, daß** der Verbindungsbereich der etwa einander entgegengesetzt sich erstreckenden Federarme (17) außerhalb einer Verbindungslinie zwischen den Befestigungsstellen angeordnet ist.

8. Befestigungsvorrichtung nach Anspruch 7, **dadurch gekennzeichnet, daß** das Federelement (16) etwa U-förmig ausgebildet ist und aus zwei spiegelbildlich zueinander angeordneten L-förmigen Federarmen (17) besteht, in deren Verbindungsbereich der Rastansatz (20) angeordnet ist.

9. Befestigungsvorrichtung nach einem der Ansprüche 3 bis 8, **dadurch gekennzeichnet, daß** das Federelement (16) ein einteiliges, insbesondere aus Kunststoff bestehendes Bauteil ist.

10. Befestigungsvorrichtung nach einem der vorhergehenden Ansprüche, **dadurch gekennzeichnet, daß** an einem Erdungsbereich des Gehäuses des Moduls oder an einer Wand des mit Erde verbundenen Blechrahmens (1) insbesondere eine als Erdungsfederarm (27) ausgebildete Erdungsfeder angeordnet ist, die mit federnder Vorspannung an einem Erdungsbereich des Gehäuses (14) des Moduls (13) oder an einer Wand des Blechrahmens in Anlage ist.

11. Befestigungsvorrichtung nach einem der vorhergehenden Ansprüche, **dadurch gekennzeichnet, daß** die Fixierelemente (21) und/oder die radialen Erweiterungen (25) einen Kreisquerschnitt besitzen.

12. Befestigungsvorrichtung nach Anspruch 11, **dadurch gekennzeichnet, daß** die Fixierelemente (21) bolzenartig ausgebildet sind und eine radial umlaufende Nut (22) besitzen, deren Nutbreite (23) etwa der Dicke der Seitenwand (2) des Blechrahmens (1) und deren Durchmesser (24) am Nutengrund etwa der Breite der Fixieröffnung (5, 5', 6, 6') und des Einführbereichs entspricht.

13. Befestigungsvorrichtung nach einem der vorhergehenden Ansprüche, **dadurch gekennzeichnet, daß** die Fixieröffnungen (5, 5', 6, 6') mit den Einführbereichen durch Langlöcher (7, 7') gebildet sind.

14. Befestigungsvorrichtung nach Anspruch 12, **dadurch gekennzeichnet, daß** ein Teil des Urrigebungsbereichs der Fixieröffnungen (5, 5') als Federarm (10) ausgebildet ist und federnd an der einen Seitenwand, insbesondere der dem Modul (13) entfernteren Seitenwand der Nut (22) in Anlage ist, während der andere Teil des Umgebungsbereichs an der anderen Seitenwand der Nut (22) abgestützt ist.

15. Befestigungsvorrichtung nach einem der vorhergehenden Ansprüche, **dadurch gekennzeichnet, daß** die Anschlußöffnung (12) ein Langloch ist, das sich etwa parallel zur Erstreckung der Einführbereiche erstreckt.

16. Befestigungsvorrichtung nach einem der vorhergehenden Ansprüche, **dadurch gekennzeichnet, daß** das Anschlußteil (15) sich etwa parallel zur Ebene der Seitenwand (2) des Blechrahmens (1) erstreckt und die Anschlußöffnung (12) in einer zur Seitenwand (2) etwa rechtwinklig sich erstreckenden Rückwand (3) des Blechrahmens (1) ausgebildet ist.

17. Befestigungsvorrichtung nach einem der vorhergehenden Ansprüche, **dadurch gekennzeichnet, daß** der Blechrahmen (1) ein Stanz/Biegebauteil ist.

## Claims

1. Releasable fastening apparatus for an electronic module, in particular for a GPS receiver of a motor vehicle, on a side wall of a sheet-metal frame, having an approximately box-like housing of the module, from which housing a connection part, in particular an antenna connection part, projects and protrudes through a connection opening in a wall of the sheet-metal frame, having fixing elements which project from the box-like housing and project through fixing openings in the side wall of the sheet-metal frame when the module is in the fastened position on the sheet-metal frame, and by way of radial extensions bear against the surrounding region of the fixing openings, so as to surround said surrounding region, on that side of the side wall of the module which is averted from the module, having mounting openings in the side wall, into which mounting openings fixing openings issue via insertion regions which extend in the same direction, it being possible for the radial extensions to be routed through the mounting openings transverse to the plane of the side wall, and for the fixing elements to be routed through the insertion regions in the plane of the side wall, **characterized in that** at least one spring element (16) is arranged on the housing (14) of the module (13), it being possible for the said spring element to be supported, under spring prestress, on that surface of the side wall (2) which faces the module (13) and to have a latching projection (20) which is directed towards the side wall (2) and latches into a latching opening (11), of approximately corresponding cross section, of the sheet-metal frame (1) in a sprung manner in the fastening position.

2. Fastening apparatus according to Claim 1, **characterized in that** a spring element (16) is arranged in the mutually opposing end regions of the module (13) in each case.

3. Fastening apparatus according to either of the preceding claims, **characterized in that** the spring element (16) has a plurality of spring arms (17), of which two extend approximately in opposite directions to an edge region of the module (13) in each case.

4. Fastening apparatus according to Claim 3, **characterized in that** the latching projection (20) is arranged in the connecting region of the spring arms (17).

5. Fastening apparatus according to either of Claims 3 and 4, **characterized in that** the spring arms (17) which extend approximately in opposite directions to one another are inclined at an angle in relation to one another in such a way that the greatest distance from the housing (14) of the module (13) is formed in their connecting region.

6. Fastening apparatus according to one of Claims 3 to 5, **characterized in that** the ends of the spring arms (17) which extend towards the edge region of the module (13) can be fastened to fastening points on the housing (14) of the module (13).

7. Fastening apparatus according to one of Claims 3 to 6, **characterized in that** the connecting region of the spring arms (17) which extend approximately in opposite directions to one another is arranged outside a connecting line between the fastening points.

8. Fastening apparatus according to Claim 7, **characterized in that** the spring element (16) is of approximately U-shaped design and comprises two L-shaped spring arms (17) which are arranged with mirror-image symmetry to one another, and the latching projection (20) is arranged in the connecting region of the said spring arms.

9. Fastening apparatus according to one of Claims 3 to 8, **characterized in that** the spring element (16) is an integral component, in particular one which is composed of plastic.

10. Fastening apparatus according to one of the preceding claims, **characterized in that**, in particular, an earthing spring which is in the form of an earthing spring arm (27) is arranged on an earthing region of the housing of the module or on a wall of the sheet-metal frame (1) which is connected to earth, the said earthing spring bearing with spring prestress against an earthing region of the housing (14) of the module (13) or against a wall of the sheet-metal frame.

11. Fastening apparatus according to one of the preceding claims, **characterized in that** the fixing elements (21) and/or the radial extensions (25) have a circular cross section.

12. Fastening apparatus according to Claim 11, **characterized in that** the fixing elements (21) are of pin-like design and have a radially circumferential groove (22), of which the groove width (23) corresponds approximately to the thickness of the side wall (2) of the sheet-metal frame (1) and of which the diameter (24) at the groove base corresponds approximately to the width of the fixing opening (5, 5', 6, 6') and of the insertion region.

13. Fastening apparatus according to one of the preceding claims, **characterized in that** the fixing openings (5, 5', 6, 6') with the insertion regions are formed by elongate holes (7, 7').

14. Fastening apparatus according to Claim 12, **characterized in that** a portion of the surrounding region of the fixing openings (5, 5') is in the form of a spring arm (10) and bears in a sprung manner against one side wall, in particular that side wall of the groove (22) which is further away from the module (13), whereas the other portion of the surrounding region is supported on the other side wall of the groove (22).

15. Fastening apparatus according to one of the preceding claims, **characterized in that** the connection opening (12) is an elongate hole which extends approximately parallel to the extent of the insertion regions.

16. Fastening apparatus according to one of the preceding claims, **characterized in that** the connection part (15) extends approximately parallel to the plane of the side wall (2) of the sheet-metal frame (1) and the connection opening (12) is formed in a rear wall (3) of the sheet-metal frame (1), which rear wall extends approximately at a right angle to the side wall (2) .

17. Fastening apparatus according to one of the preceding claims, **characterized in that** the sheet-metal frame (1) is a stamped/bent component.

## Revendications

1. Dispositif détachable pour la fixation d'un module électronique, notamment d'un récepteur GPS dans un véhicule automobile, à la paroi latérale d'un cadre en tôle, ledit dispositif comportant un coffret du module ayant approximativement la forme d'une boîte, sur lequel coffret fait saillie une pièce de raccordement, notamment une pièce de raccordement d'antenne, qui dépasse à travers une ouverture de raccordement pratiquée dans une paroi du cadre en tôle, des éléments de fixation faisant saillie du coffret en forme de boîte, lesquels éléments de fixation dépassent, dans la position de fixation du module sur le cadre en tôle, à travers des ouvertures de fixation pratiquées dans la paroi latérale du cadre en tôle et lesquels éléments de fixation s'appliquent, par des prolongements dans le sens radial proches des ouvertures de fixation en les entourant, sur la face opposée au module de la paroi latérale du module, des ouvertures de montage dans la paroi latérale dans lesquelles débouchent des ouvertures de fixation par l'entremise de zones d'introduction qui s'étendent dans la même direction, où les prolongements dans le sens radial pouvant être introduits perpendiculairement au plan de la paroi latérale à travers les ouvertures de montage et les éléments de fixation pouvant être introduits dans le plan de la paroi latérale à travers les zones d'introduction, **caractérisé par le fait que**, sur le coffret (14) du module (13), est disposé au moins un élément à ressort (16) qui s'appuie, sous l'effet d'une précontrainte élastique sur la surface de la paroi latérale (2) tournée vers le module (13) et qui présente un téton d'encliquetage (20) orienté vers la paroi latérale (2), lequel téton d'encliquetage est encliqueté, dans la position de fixation, d'une façon élastique dans une ouverture d'encliquetage (11) du cadre en tôle (1) laquelle a une section transversale approximativement correspondante.

2. Dispositif de fixation selon la revendication 1, **caractérisé par le fait qu'**un élément à ressort (16) est placé dans chacune des zones terminales du module (13) qui sont respectivement opposées.

3. Dispositif de fixation selon l'une des revendications précédentes, **caractérisé par le fait que** l'élément à ressort (16) comporte plusieurs branches élastiques (17) s'étendant deux à deux approximativement en sens contraire l'une par rapport à l'autre vers l'une des zones de bordure du module (13).

4. Dispositif de fixation selon la revendication 3, **caractérisé par le fait que** le téton d'encliquetage (20) est placé dans la zone de jonction des branches élastiques (17).

5. Dispositif de fixation selon l'une des revendications 3 et 4, **caractérisé par le fait que** les branches élastiques (17) s'étendant approximativement en sens contraire l'une par rapport à l'autre sont inclinées l'une par rapport à l'autre d'un certain angle de telle sorte que leur écartement du coffret (14) du module (13) est maximum dans leur zone de jonction.

6. Dispositif de fixation selon l'une des revendications 3 à 5, **caractérisé par le fait que** les extrémités des branches élastiques (17) s'étendant vers les zones de bordure du module (13) peuvent être fixées à des points de fixation placés sur le coffret (14) du module (13).

7. Dispositif de fixation selon l'une des revendications 3 à 6, **caractérisé par le fait que** la zone de jonction des branches élastiques (17) s'étendant approximativement en sens contraire l'une par rapport à l'autre se trouve à l'extérieur d'une ligne de jonction entre les points de fixation.

8. Dispositif de fixation selon la revendication 7, **caractérisé par le fait que** l'élément à ressort (16) a approximativement une forme de U et se compose de deux branches de ressort (17) en forme de L placées inversement l'une par rapport à l'autre, le téton d'encliquetage (20) se trouvant dans leur zone de jonction.

9. Dispositif de fixation selon l'une des revendications 3 à 8, **caractérisé par le fait que** l'élément à ressort (16) est une pièce en une seule partie, notamment en matière plastique.

10. Dispositif de fixation selon l'une des revendications précédentes, **caractérisé par le fait que**, dans une zone de mise à la masse du coffret du module ou sur une paroi du cadre en tôle (1) reliée à la masse, est placé notamment un ressort de mise à la masse conçu sous la forme de branche de ressort (27) de mise à la masse, qui s'applique sous l'effet d'une force élastique de contrainte sur une zone de mise à la masse du coffret (14) du module (13) ou sur une paroi du cadre en tôle.

11. Dispositif de fixation selon l'une des revendications précédentes, **caractérisé par le fait que** les éléments de fixation (21) et/ou les prolongements (25) dans le sens radial ont une section transversale circulaire.

12. Dispositif de fixation selon la revendication 11, **caractérisé par le fait que** les éléments de fixation (21) sont conçus en forme de tourillons et ont une rainure (22) radialement périphérique, dont la largeur (23) correspond approximativement à l'épaisseur de la paroi latérale (2) du cadre en tôle (1) et dont le diamètre (24) au fond de la rainure correspond approximativement à la largeur de l'ouverture de fixation (5, 5', 6, 6') et de la zone d'introduction.

13. Dispositif de fixation selon l'une des revendications précédentes, **caractérisé par le fait que** les ouvertures de fixation (5, 5', 6, 6') et les zones d'introduction sont formées par des trous oblongs (7, 7').

14. Dispositif de fixation selon la revendication 12, **caractérisé par le fait qu'**une partie de la zone voisine des ouvertures de fixation (5, 5') est conçue sous forme de branche de ressort (10) et est appliquée d'une façon élastique sur l'une des parois latérales, notamment sur la paroi latérale de la rainure (22) la plus éloignée du module (13), alors que l'autre partie de la zone voisine des ouvertures de fixation (5, 5') appuie sur l'autre paroi latérale de la rainure (22).

15. Dispositif de fixation selon l'une des revendications précédentes, **caractérisé par le fait que** l'ouverture de raccordement (12) est un trou oblong qui se développe à peu près parallèlement à la longueur des zones d'introduction.

16. Dispositif de fixation selon l'une des revendications précédentes, **caractérisé par le fait que** la pièce de raccordement (15) se développe à peu près parallèlement au plan de la paroi latérale (2) du cadre en tôle (1) et que l'ouverture de raccordement (12) est ménagée dans une paroi arrière (3) du cadre en tôle (1) qui se développe à peu près à angle droit par rapport à la paroi latérale (2).

17. Dispositif de fixation selon l'une des revendications précédentes, **caractérisé par le fait que** le cadre en tôle (1) est une pièce estampée et pliée.
